# EUROPEAN PATENT APPLICATION

(11) **EP 4 804 747 A1**
(43) Date of publication of application: **09.09.2026**
(21) Application number: 26160808.7
(22) Date of filing: 25.02.2026
(51) Int. Cl.: H05K 7/20

(54) **RACK MOUNTABLE COOLING SYSTEMS AND METHODS**

(30) Priority: 25.02.2025 US 202563763166 P
(71) Applicant: Schroff GmbH, 75334 Straubenhardt (DE)
(72) Inventor: Sitzler, Patrick, Neuthard (DE); Dizel, Sergej, Ettlingen (DE); Ganninger, Christian, Remchingen (DE); Adel, Hassan Elsheshtawy, Dobel (DE)
(74) Representative: Barker Brettell LLP

(57) **Abstract**

A cooling unit (1102) for an enclosure that is an electronics rack can include a housing (1122) defining an internal volume (1134), a barrier (1136) separating the internal volume into a first portion (1138) of the internal volume and a second portion (1140) of the internal volume, a first inlet (1104) directing first air into the first portion of the internal volume, a second inlet (1106) directing second air into the second portion of the internal volume, a first outlet fluidly coupled to the first portion of the internal volume, a second outlet fluidly coupled to the second portion of the internal volume, a first heat exchanger (1114) positioned within the internal volume and fluidly coupled to the first inlet, and a second heat exchanger (1116) positioned within the internal volume and fluidly coupled to the second inlet.

## Description

### BACKGROUND

Cooling systems can be provided for electrical components in data centers. In some cases, a flow of air across electrical equipment can cool electrical equipment within a data center. For example, in operation, electrical equipment (e.g., processing cores, central processing units ("CPUs"), graphics processing units ("GPUs"), application specific integrated chips ("ASICs"), network cards, etc.) can generate heat and transferring that heat from the electrical equipment can prevent damage to the electrical equipment and extend an operable life span of the electrical equipment. Within a data center, electrical equipment can be arranged within racks or other enclosures between a hot aisle and a cold aisle, and a flow of air can be induced from the cold aisle to the hot aisle through the rack or other enclosures (e.g., using fans) to cool the electrical equipment within the enclosure or rack.

### SUMMARY OF THE DISCLOSURE

According to some aspects of the present disclosure, a cooling unit for an enclosure that is an electronics rack can include a housing defining an internal volume, a barrier separating the internal volume into a first portion of the internal volume and a second portion of the internal volume, a first inlet directing first air into the first portion of the internal volume, a second inlet directing second air into the second portion of the internal volume, a first outlet fluidly coupled to the first portion of the internal volume, a second outlet fluidly coupled to the second portion of the internal volume, a first heat exchanger positioned within the internal volume and fluidly coupled to the first inlet, and a second heat exchanger positioned within the internal volume and fluidly coupled to the second inlet. The first air can flow along a first flow path through the first inlet, across the first heat exchanger thereby cooling the air, and out the first outlet to direct the cooled first air to a card cage having one or more electrical computing components therein. The second air can flow along a second flow path through the second inlet, across the second heat exchanger thereby transferring heat from the second heat exchanger to the second air, and out the second outlet to direct the heated second air out of the enclosure.

In some examples, a cooling unit can be dimensioned to be placed in the enclosure. The enclosure can be an electronics rack that includes a card cage supporting one or more electrical computing components.

In some examples, a first heat exchanger can be positioned between a first inlet and a first outlet.

In some examples, a longitudinal axis of a first heat exchanger can be substantially parallel to a longitudinal axis of a housing of a cooling unit. Second air can flow substantially perpendicular relative to the longitudinal axis of the cooling unit.

In some examples, a cooling unit can include a refrigeration loop that fluidly couples a refrigerant to a first heat exchanger and a second heat exchanger. The refrigerant can be a two-phase liquid refrigerant.

In some examples, a longitudinal axis of a first heat exchanger can be substantially perpendicular to a longitudinal axis of a housing of a cooling unit.

In some examples, a cooling unit can include a first fan fluidly coupled to a first inlet. The first fan can be positioned downstream of the first inlet. The cooling unit can include a second fan fluidly coupled to a second inlet. The second fan can be positioned upstream of a second heat exchanger.

In some examples, a cooling unit can include an extension coupled to a housing. The extension can define a first inlet and a first portion of an internal volume. A first heat exchanger can be positioned within the extension. A first flow path can be substantially parallel to a second flow path.

In some examples, an extension can be aligned with a card cage supported by an enclosure when installed. Cooled first air can flow substantially parallel to a longitudinal axis of a housing.

In some examples, a top wall of a housing of a cooling unit can define a barrier.

In some examples, a longitudinal axis of a first heat exchanger can be substantially perpendicular to a longitudinal axis of the second heat exchanger. In some cases, the longitudinal axis of the first heat exchanger can be substantially parallel to the longitudinal axis of the second heat exchanger.

According to some aspects of the present disclosure, a cooling unit for an enclosure that is an electronics rack can include a housing defining an internal volume and including a top wall, a bottom wall, a first end wall, and second end wall. The cooling unit can include a first inlet directed into the first end wall, a second inlet directed into the first end wall, a first outlet being fluidly coupled to the first inlet, a second outlet being fluidly coupled to the second inlet, a first heat exchanger positioned within the internal volume and fluidly coupled to the first inlet, and a second heat exchanger positioned within the internal volume and fluidly coupled to the second inlet. First air can pass through the first inlet, across a thickness of the first heat exchanger thereby cooling the first air, and out the first outlet to direct the cooled first air into a card cage having one or more electrical computing components therein. Second air can pass through the second inlet, across a thickness of the second heat exchanger thereby transferring heat from the second heat exchanger to the second air, and out the second outlet to direct the heated second air out of the enclosure.

In some examples, a first outlet can be directed into a top wall of a housing. A longitudinal axis of a first heat exchanger can be substantially parallel to a longitudinal axis of a housing of a cooling unit. The longitudinal axis of the first heat exchanger can be substantially perpendicular to a longitudinal axis of the second heat exchanger. The first heat exchanger can be coupled to the top wall of the housing. The first heat exchanger can be an evaporator and the second heat exchanger can be a condenser. The evaporator can be a liquid-to-air evaporator and the condenser can be a liquid-to-air condenser.

In some examples, a housing can include an extension extending upwardly away from the top wall of the housing. The extension can define a first inlet and a first outlet. A first heat exchanger can be positioned within the extension.

According to some aspects of the present disclosure a method of installing a cooling unit within an enclosure that is a electronics rack can include positioning the cooling unit in the enclosure below a card cage to be cooled, the cooling unit including a first inlet, a second inlet, a first outlet, a second outlet, a first heat exchanger, and a second heat exchanger. The method can include directing first air through a first inlet, across the first heat exchanger thereby cooling the first air, and out the first outlet into the card cage. The method can include directing second air through a second inlet, across the second heat exchanger thereby transferring heat from the second heat exchanger to the second air, and out the second outlet and out of the enclosure.

In some examples, a cooling unit can include a barrier that separates an internal volume of a housing of a cooling unit into a first portion and a second portion. A first inlet and a first outlet can be fluidly coupled to the first portion of the internal volume. A second inlet and the second outlet are fluidly coupled to the second portion of the internal volume.

In some examples, an enclosure can include a first fan and a cooling unit can include a second fan. A method can include activating the first fan to direct first air through the cooling unit and activating the second fan to direct second air through the cooling unit.

In some examples, a cooling unit can include an extension. The extension can be positioned in front of a card cage when the cooling unit is positioned in an enclosure. A first heat exchanger can be positioned within the extension. A method can include directing cooled first air through a side of the card cage.

In some examples, a cooling unit can include a first fan and a second fan. A method can include activating the first fan to direct first air through the cooling unit and activating the second fan to direct second air through the cooling unit.

In some examples, a first heat exchanger can be downstream of a first inlet and a second heat exchanger can be positioned upstream of a second outlet.

Some aspects of the disclosure provide a cooling unit for an enclosure. The cooling unit can include a housing defining an internal volume and a barrier separating the internal volume into a first portion of the internal volume and a second portion of the internal volume. The first portion of the internal volume can be fluidly isolated from the second portion of the internal volume. The cooling unit can include a first inlet fluidly coupled to the first portion of the internal volume, a second inlet fluidly coupled to the second portion of the internal volume, and a heat exchanger positioned within the internal volume and fluidly coupled to the second inlet.

In some examples, a cooling unit can include an outlet fluidly coupled to a second portion of an internal volume and a fan positioned upstream of the outlet.

In some examples, a heat exchanger can be a first heat exchanger. A cooling unit can include a second heat exchanger positioned within an internal volume and fluidly coupled to a first inlet.

In some examples, a fan can be a first fan. A cooling unit can include a second fan. The second fan can be positioned within or downstream of a first inlet.

According to some aspects of the disclosure an in-rack cooling unit can include a chassis having a height of two rack units defining an air inlet at a front of the chassis, a primary air outlet at a top of the chassis, and a secondary air outlet at a back of the chassis. The cooling unit can include a refrigerant loop that can include a condenser positioned fluidly between the air inlet and the secondary outlet and an evaporator positioned fluidly between the air inlet and the primary outlet.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the cooling unit or any feature(s) or component(s) described may have corresponding features definable and/or combinable with respect to a method or vice versa, and these embodiments are specifically envisaged.

### DESCRIPTION OF THE DRAWINGS

FIG. 1 is a perspective view of a cage for housing computing cards.
FIG. 2 is a schematic view of a system for cooling computing cards within a card cage.
FIG. 3 is an isometric view of a cooling unit according to some examples.
FIG. 4 is a front elevation view of the cooling unit of FIG. 3.
FIG. 5 is a rear elevation view of the cooling unit of FIG. 3.
FIG. 6 is a schematic view of a cooling unit for cooling electrical cards within a card cage, according to some examples.
FIG. 7 is an isometric view of a cooling unit according to some examples of the present disclosure.
FIG. 8 is a front elevation view of the cooling unit of FIG. 7, showing an air flow path through the cooling unit.
FIG. 9 is a schematic side view of the cooling unit of FIG. 7, according to some examples.
FIG. 10 is a top diagrammatic top view of the cooling unit of FIG. 7.
FIG. 11 shows a diagrammatic view of a cooling system.
FIG. 12 shows a diagrammatic view of another example of a cooling system.
FIG. 13 shows a diagrammatic view of yet another example of a cooling system.
FIG. 14 shows a front isometric view of an example of a cooling unit.
FIG. 15 shows a rear isometric view of the cooling unit of FIG. 14.
FIG. 16 shows a top view of the cooling unit of FIG. 14.
FIG. 17 shows a front isometric view of the cooling unit of FIG. 14 with the top removed for visual clarity.
FIG. 18 shows a front isometric view of the cooling unit of FIG. 14 with the front removed for visual clarity.
FIG. 19 shows a cross-sectional view of the cooling unit of FIG. 14 taken along lines 19-19 of FIG. 16.
FIG. 20 shows a flowchart of a process of installing a cooling unit within an enclosure (e.g., an electronics rack) and cooling components of the enclosure.

### DETAILED DESCRIPTION

Before any examples of the present disclosure are explained in detail, it is to be understood that the present disclosure is not limited in its application to the details of construction and the arrangement of components set forth in the following description or illustrated in the following drawings. The disclosed systems and methods are capable of other examples and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

In operation, electrical equipment generates heat that, in some cases, can be transferred away from electrical equipment to prevent a degrading or a destruction of the electrical equipment. For example, modern computing loads require large amounts of electrical computing equipment (e.g., servers, networking switches, storage devices, etc.) to support given computational loads. Computing equipment within a data center can be arranged in racks (e.g., in shelves of racks), which in turn can be arranged in rows within a data center.

In common cabinet applications there are often multiple rack components with different purposes and thermal ratings assembled in one cabinet. Conventionally, a single cooling solution is used for cooling all equipment within a given cabinet. With increasing processing power and integration density according power ratings, there can be imbalances among the used rack components which will cause hotspots, deratings of components, reduced operational ranges and thermal stress for the end application.

In some applications, a cabinet can include one or more chassis housing computing components for processing different computing workloads. In some cases, chasses mounted within a cabinet can comprise card cages (e.g., chasses including standard slots for housing standard 19" 19" 160-180mm card cage inlets into which printed circuit board cards can be inserted). Card cages can include bays for receiving removable computing cards (e.g., including PCBs with CPUs, GPUs, ASICs, etc.). Removable computing cards can comprise a casing having standardized dimensions and interfaces, sized and shaped to be received into bays of the casing. When installed within a casing, electrical connections of the computing cards can interface with corresponding connections within the case. In some examples, computing cards can include processors that can generate a heat in operation. Cards can range in depth up to approximately 6.5 inch, in height from approximately 5 inch to 10 inch, and can be up to 4 inch wide, depending on the number and size of components included on the card.

In some conventional systems, as described below, computing cards within a card cage can be air cooled, with air flowing into the card cage through an air inlet in a bottom of the card cage (e.g., an end of the card cage most proximate to a floor surface). The air can flow upwardly across the computing cards to cool the cards and can flow out of the card cage at an air outlet. In some cases, an open space (e.g., a plenum) can be provided beneath a card cage, with an opening facing a front of a rack. For example, a 1U space beneath a card cage can be left open (e.g., absent of computing components) and air can flow into a bottom of the card cage through the empty space. In some cases, computing cards within a card cage can have different cooling requirements than other components within the cabinet in which the card cage is mounted (e.g., servers, network cards, storage or drives, computing cards housed within other card cages, etc.). An air temperature of an air flowing through the cabinet can be insufficient or inefficient (e.g., requiring a greater air flow) for cooling high-performance or high-density computing cards within a given cage of a rack, even while potentially being sufficient for cooling other electrical equipment within the rack.

Some examples of the present disclosure can provide targeted cooling for specific chasses (e.g., card cages) within a rack of electrical equipment. In some examples of the present disclosure, a cooling unit can be provided defining an air-flow path between an inlet at a front (e.g., a cold-aisle facing side) of the unit, and an outlet at a top of the unit. In some cases, a cooling unit can be sized to fit within a 2U space of a rack and can be installed beneath a card cage within the rack. The cooling unit can include a heat exchanger for transferring a heat from an air to cool the air upstream of the air inlet of the card cage. In some cases, a cooling unit can include a refrigerant-based cooling system to chill an air flowing through the cooling unit, thereby increasing a cooling capacity of the cooling unit. A cooling unit, according to the present disclosure can provide the benefit of liquid cooling systems even where fluid connections to a liquid cooling system may not be available by providing a self-contained refrigeration cycle (e.g., a two-phase refrigeration cycle) within the cooling unit, thereby eliminating the need to connect to liquid cooling circuits within a data center. In some examples, a cooling unit can optionally provide the capacity to connect to liquid cooling systems of a data center and can perform a heat exchange through an air-to-liquid heat exchanger.

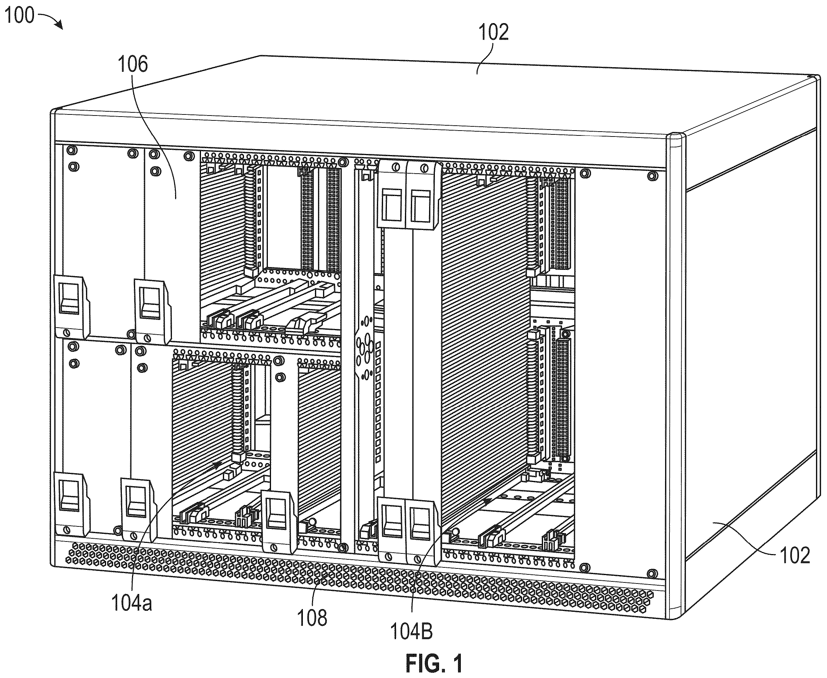

FIG. 1 illustrates a 1U card cage 100 according to some examples. The cage 100 is used for housing removable computing cards within a rack (e.g., an electronics rack that supports one or more computing components), of, for example, in industrial settings, embedded computing applications, a data center, etc. In some cases, an electronics rack can be a data center electronics rack, a computing rack, a testing electronics rack, a measurement electronics rack, a test and measurement rack (e.g., electronics rack), an instrument rack, etc. In the example shown, the cage 100 is a 19-inch case sized to be received into a rack having standard dimensions. Further, in the illustrated example, the cage 100 includes a plurality of side walls 102 to at least partially enclose the electrical cards within the cage 100, and to constrain a flow of air (e.g., the side walls 102 can function as baffles to prevent air flow out of the cage at the respective side walls 102). The cage 100 includes a plurality of bays 104. In the illustrated example, the bays 104 include bays having different dimensions for receiving differently sized computing cards. For example, the bays 104a define a height that is less than the height of the bays 104b, to accommodate differing sizes of computing cards.

As shown, the cage 100 further includes computing components 106 (e.g., computing cards holding CPUs, GPUs, ASICs, FGPAs, etc.) installed within the cage 100. The computing components 106, which can be in the form of one or more cards, can be sized and shaped to be received into a corresponding one of the bays 104 and can include electrical equipment that can generate a heat in operation. As shown, the cage includes features for providing an air flow across the electrical components 106 within the cage 100. Typically, a 1U space is provided under the cage, either as an inlet integral to the cage, or by leaving a 1U space open beneath the cage. For example, an air inlet 108 is shown at a bottom of the cage. The air inlet 108 can receive an ambient air (e.g., an air conditioned or otherwise cooled air from a cold aisle of a datacenter) and can allow the air to flow into the cage 100 to a plenum defined beneath the electrical cards 106. Air can flow upwardly across the computing components 106 from the plenum and can exit the cage 100 at an outlet (not shown) provided in a back of the cage 100. In some examples, if a bay of a cage does not include a computing card installed therein, the bay can be blocked with a baffle to prevent an entry of particulate matter into the cage 100 and to increase an efficiency of air flow through the computing components 106 within the cage 100.

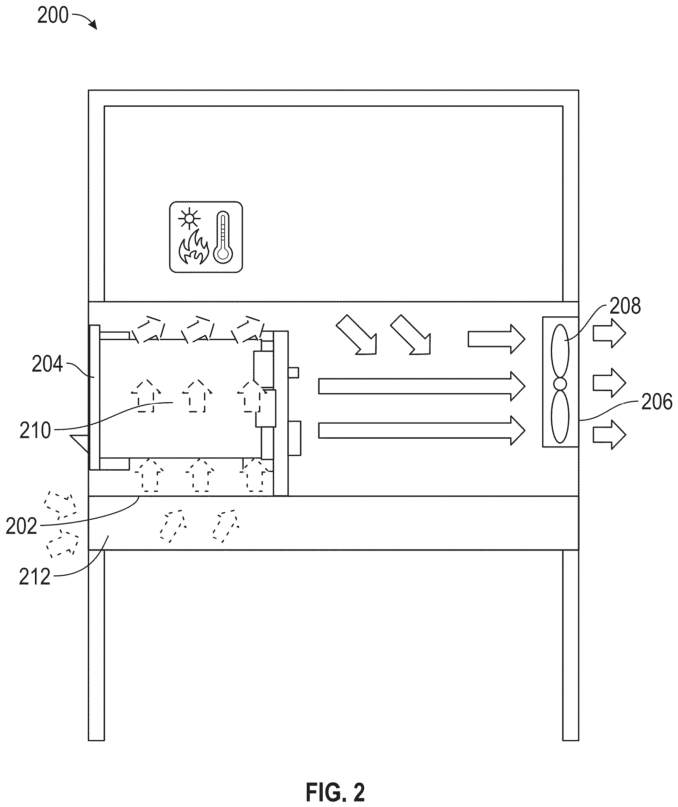

FIG. 2 shows a schematic of a cooling system 200 for targeting a card cage 204 (e.g., similar to card cage 100 shown in FIG. 1). In this example, ambient air enters the 1U empty space 212 below the cage 204, and flows into the cage air inlet 202 and through the card cage 204. As the air flows through the cage 204, the electrical components 210 are cooled, and heated air is expelled. In some scenarios, the cooling systems 200 can include fans 208, that guide air flow to the outlet 206. In some cases, as illustrated, a cooling capacity for the system 200 is dependent on a temperature of an ambient air. Thus, in some cases, where a difference between a temperature of the ambient air and an operating temperature of the electrical cards 210 is too small, and the electrical equipment can be ineffectively or inefficiently cooled (e.g., the computing equipment can experience an overheating event). As computing cards provide greater density and computing capacity, they increasingly generate greater amounts of heat. There is therefore a need to provide systems for cooling an air from an ambient temperature to meet the cooling needs of particular card cages (e.g., computing cards within the cages).

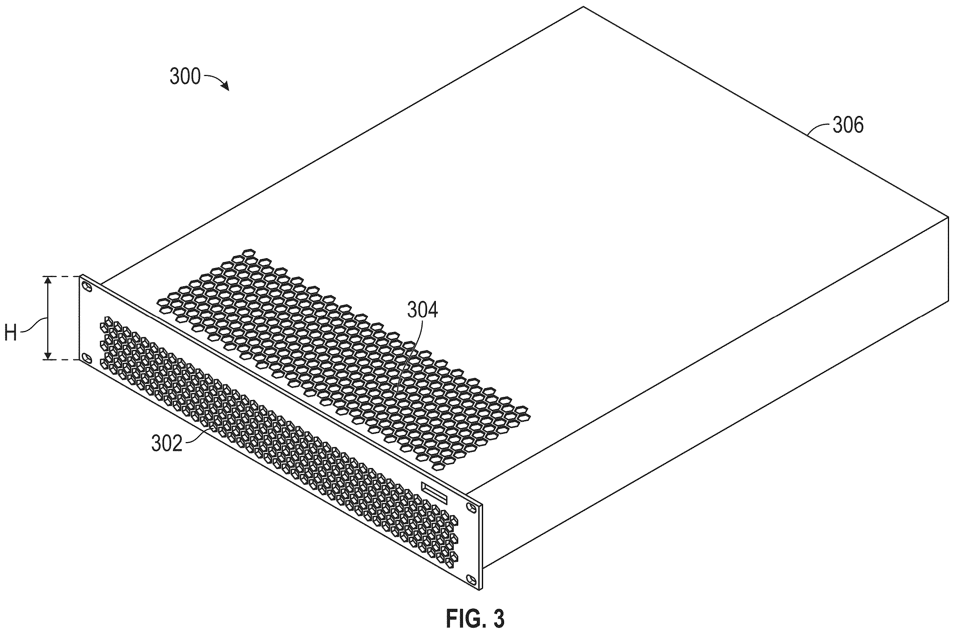

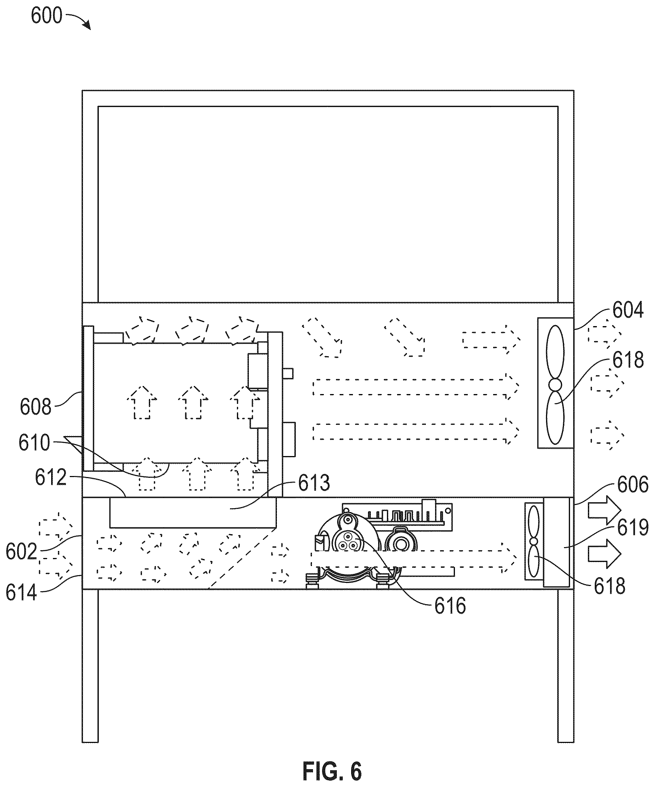

Some examples of the present disclosure can provide a rack-mountable cooling unit, which can be placed in a space underneath a card cage with a bottom air inlet, and cools air from a prevailing inner cabinet ambient air temperature to a target temperature through use of a high-performance heat exchanger. In some cases, a cooling unit can be 2U-height 19"-wide slide-in unit with a perforated front for air intake, and one or more perforations in a top of the unit facing the bottom air inlet of the target card cage. For example, FIG. 3 illustrates an example 2U cooling unit 300. The cooling unit 300 can be sized (e.g., having a width) to be mounted within a standard 2U space of a cabinet within a rack. As shown, the cooling unit 300 has an air inlet 302 to receive ambient air. The inlet 302 can comprise an array or pattern of apertures (e.g., perforations) for allowing an air flow into the unit 300. The air inlet 302 is configured to face an aisle of a data center (e.g., a cold air aisle) to receive an air therefrom when installed in a cabinet. As shown, the cooling unit further includes a plurality of outlet apertures defining a primary outlet 304 at a top of the unit 300. The unit 300 thus defines an air flow path from the inlet 302 to the outlet 304, and when the unit is installed in a cabinet, the air expelled at the primary outlet 304 can flow into a bottom inlet of a card cage to cool the electrical components. As discussed further below with respect to FIGS. 6-10, a heat exchanger can be provided fluidically between the inlet 302 and the outlet 304 to cool the air before it flows out through the outlet 304. The heat exchanger can transfer a heat from the ambient air to a coolant fluid. In the examples described below, the coolant is a refrigerant of a closed refrigeration loop housed within the cooling unit 300. In other examples, an air-to-liquid heat exchanger can be provided between an inlet and a primary outlet of an in-rack cooling unit to transfer a heat to a liquid coolant flowing through the cooling unit (e.g., a chilled facility water). The cooling unit 300 illustrated further includes a secondary outlet 306 through which exhaust air is expelled from the unit 300.

As shown, the cooling unit 300 has a height H of 2U, though, the cooling unit 300 and others can have other heights H The cooling unit 300 can thus provide greater air flow capacity than some conventional systems which include 1U air inlets. The height of the cooling unit 300 allows for the refrigerant system to be enclosed, and provides an independent source of cooling, therefore increasing cooling capacity. The cooling unit 300 has a height H of 2U, but is still able to be it into previous systems to increase cooling capacity. In some cases, cooling units (e.g., the cooling unit 300) can be retrofit into existing systems without requiring corresponding changes in configuration for the electrical equipment to be cooled. For example, a cooling unit as disclosed herein can be installed in a space within a rack beneath an existing card cage without modification to the card cage or interruption in operation.

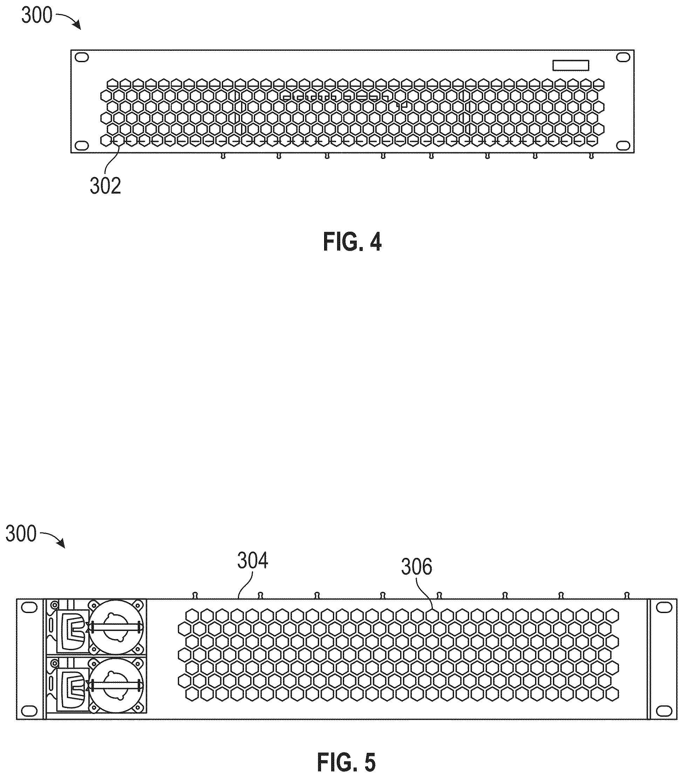

FIG. 4 illustrates a front view of the cooling unit 300. The height of the cooling unit 300 can be approximately 88.90 mm (e.g., about 2U) with a width of 483 mm (e.g., a width including tabs that can overhang posts of a 19" rack). Further, FIG. 5 shows a rear view of the cooling unit 300 with an internal width that can be about 444 mm (e.g., a width of the portion of the cooling unit housed within the rack). These dimensions allow for the cooling unit to be conform to a standard 19-inch rack of electrical equipment.

FIG. 6 shows an example of a cage cooling system 600 with a cooling unit 602 (e.g., similar to the cooling unit 300 shown in FIGS. 3-5) housed within a rack beneath a corresponding card cage 608. As shown, ambient air flows into an air inlet 614 of the cooling unit 602, across a heat exchanger 613 at which the air is cooled through a heat exchange to a coolant fluid, and out the primary outlet 612.. Cooled air flows from the primary outlet 612 and into the inlet 610 of the card cage 608 to cool electrical equipment within the card cage 608. In the illustrated example, the heat exchanger 613 is an evaporator of a refrigeration loop 616 housed within the cooling unit 602. As discussed further below, a refrigeration loop housed within a cooling unit can include an evaporator to transfer a heat from an ambient air to a coolant within the loop, as well as a condenser, and an expansion valve. As shown in the example of FIG. 6, fans 618 can be provided within the cooling unit 602 to draw a portion of the air that flows into the unit at the inlet 614 through the unit and out the secondary outlet 606. In some cases, a relative air flow through primary and secondary inlets can be configurable or controllable. For example, baffles can be provides to divide an air flow into a portion to pass through a primary outlet and a portion to pass through a secondary outlet. In some cases, an operation of the fans 618 can be controlled to achieve a desired air flow distribution. A heat exchanger 619 can be provided along an exhaust air flow path between the inlet 614 and the secondary outlet 606. In the illustrated example, the heat exchanger 619 can be a condenser of the refrigerant loop 616, and heat from the refrigerant within the refrigerant loop can be transferred to the exhaust air to cool the refrigerant before the refrigerant is cycled back to the heat exchanger 613 (e.g., implemented as a condenser) to cool the ambient air.

As the electrical components within the cage 608 are cooled, the exhaust air from the card cage 608 can be expelled through a fan 618 and out the cage outlet 604. The exhaust air from the refrigerant system 616 can also be expelled through a fan 618 and out the cooling unit outlet 606. It is important to note the air temperature expelled from the cage outlet 604 is lower than the air expelled from the cooling unit outlet 606 to prevent the degradation of the components in the card cage 608.

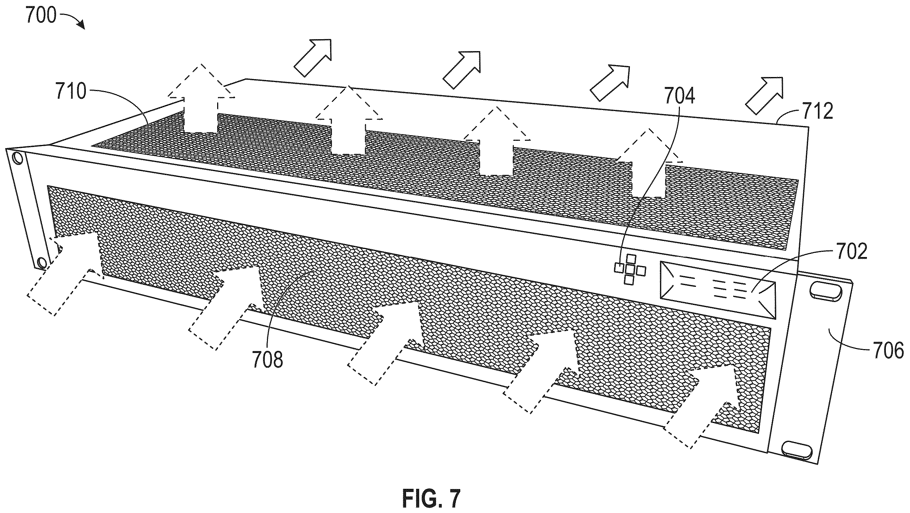

FIG. 7 illustrates another example of an in-rack cooling unit 700 (e.g., similar to the cooling unit 602 shown in FIG. 6 and the cooling unit 300 shown in FIGS. 3-5), showing the air flow of a cooling unit 700 according to an example of the invention. As shown, the cooling unit 700 includes an inlet 708 at a front, a primary outlet 709 at a top, and a secondary outlet 712 at a back of the cooling unit 700. An ambient air flows into the unit 700 at a temperature @Tambient, and is cooled at a condenser before exiting through the primary outlet at a temperature @Tcool, with @Tcool being a lower temperature than @Tambient. A portion of the air flows through the cooling unit 700, across an evaporator within the unit 700 and exits the secondary outlet 712 at a temperature @Thot, with @Thot being greater than @Tambient.

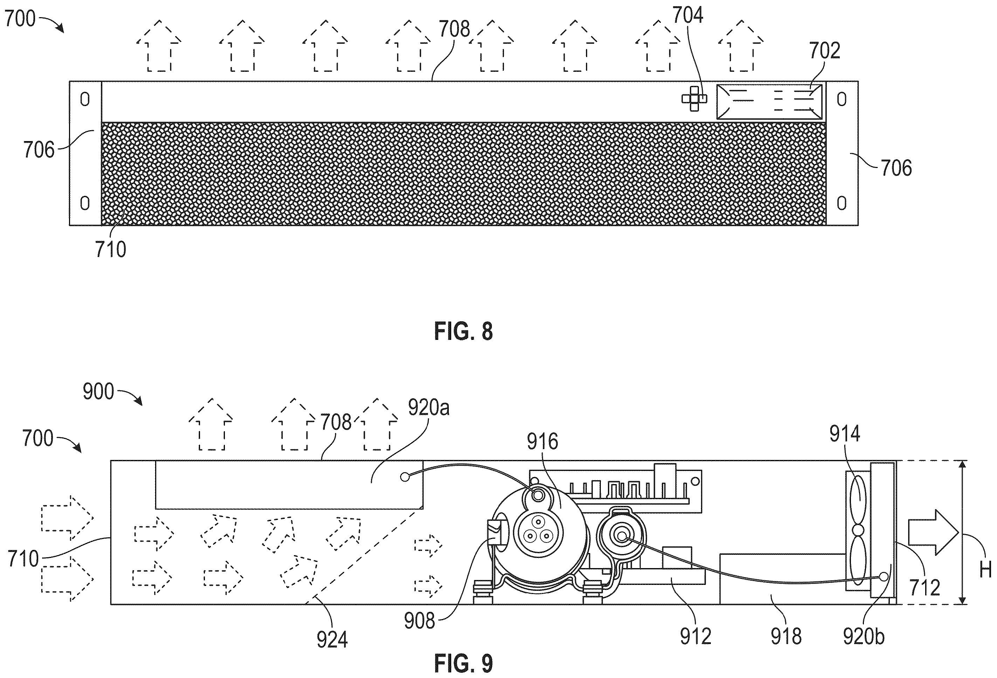

As shown, the cooling unit 700 also includes a control panel 704. The control panel 704 allows easy access for users to control the cycle of the cooling without the need to physically change the system. The cooling unit 700 further includes a liquid crystal display (LCD) 702 to indicate to users the system mode, configuration, or status of the system. The rackmount handles 706 used to secure the cooling unit 700 to a rack or card cage. FIG. 8 shows the top view of the cooling unit 700.

FIG. 9 illustrates a schematic side view of the cooling unit 700, including the refrigerant cycle 900. Ambient air enters the inlet 710 of the cooling unit 700. Some ambient air is cooled using the liquid-to-air evaporator 920a and is released through the primary outlet 709. The rest of the ambient air flows through a perforated divider 924 through an interior space of the cooling unit 700 and across a condenser 920b before exiting the cooling unit 700 through the secondary outlet 712. The refrigerant loop 900 can include the evaporator 920a, an expansion valve 908, a compressor 916, and a condenser 920b. A two-phase liquid refrigerant can be circulated through the components of the refrigeration loop 900 to provide a refrigerant-based cooling for the ambient air flowing to the card cage through the primary outlet 709.

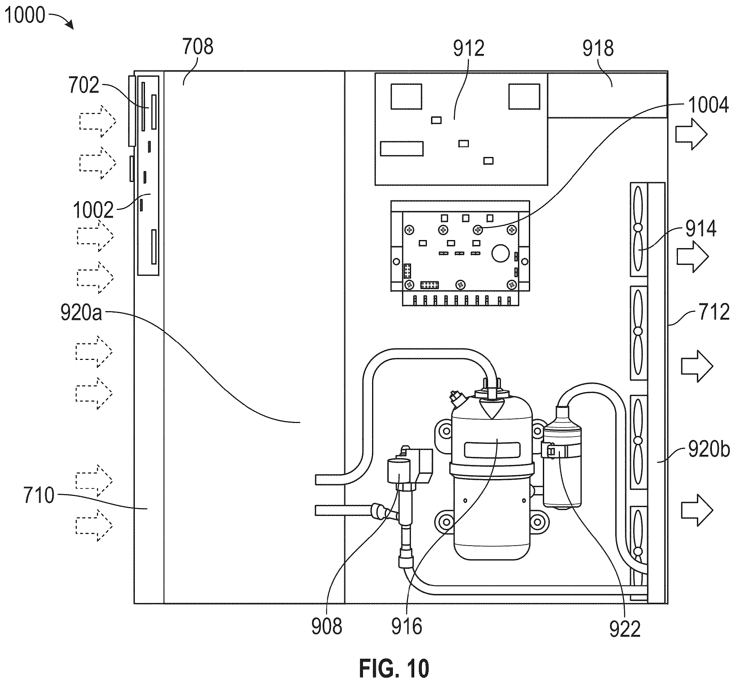

The cooling unit 700 is powered using an AC/DC power supply unit ("PSU") 918, which further supplies power to the power electronic printed circuit board ("PCB") 912. The cooling system can be powered by a wide range of input voltages. The display PCB 1002 that provides power to the LCD display 702 can be seen in FIG. 10.

FIG. 10 shows a top view of the cooling unit 700 and further illustrates the refrigerant loop 900. Ambient air enters the cooling unit 700 through the air inlet 710. Heat from the ambient air is transferred to a refrigerant (e.g., liquid refrigerant, that has, for example, a low pressure, low temperature liquid refrigerant after having passed through a metering device, such as an expansion valve) within the refrigerant loop 900 at an evaporator 920a positioned fluidly between the inlet 710 and the primary outlet 709. The compressor 916 is controlled by the variable frequency drive ("VFD") 1004, powered by the PSU 918. As the ambient air passes over the evaporator 920a, the ambient air is cooled, and heat is transferred to the liquid refrigerant and the liquid refrigerant becomes gaseous. The compressor 916 receives this low pressure gaseous refrigerant (e.g., a medium temperature, low pressure gas) and the compressor 916 increases the pressure of the refrigerant and therefore increases the temperature of the refrigerant. The hot gaseous refrigerant enters the condenser 920b and the ambient air is passed over the condenser 920b, transferring heat from the gaseous refrigerant and to the ambient air, increasing the temperature of the ambient air (which is expelled out the secondary outlet 712, such as guided by a fan array 914). As this happens, the high temperature, high pressure gaseous refrigerant condenses and liquifies into a liquid refrigerant (e.g., a medium temperature, high pressure liquid refrigerant), where the liquid refrigerant is passed to the expansion valve 908. From the expansion valve 908, the liquid refrigerant is cooled and the pressure is lowered. This liquid refrigerant is then passed to the evaporator 920a, creating a coolant loop. The cooled air is expelled through the primary outlet 709.

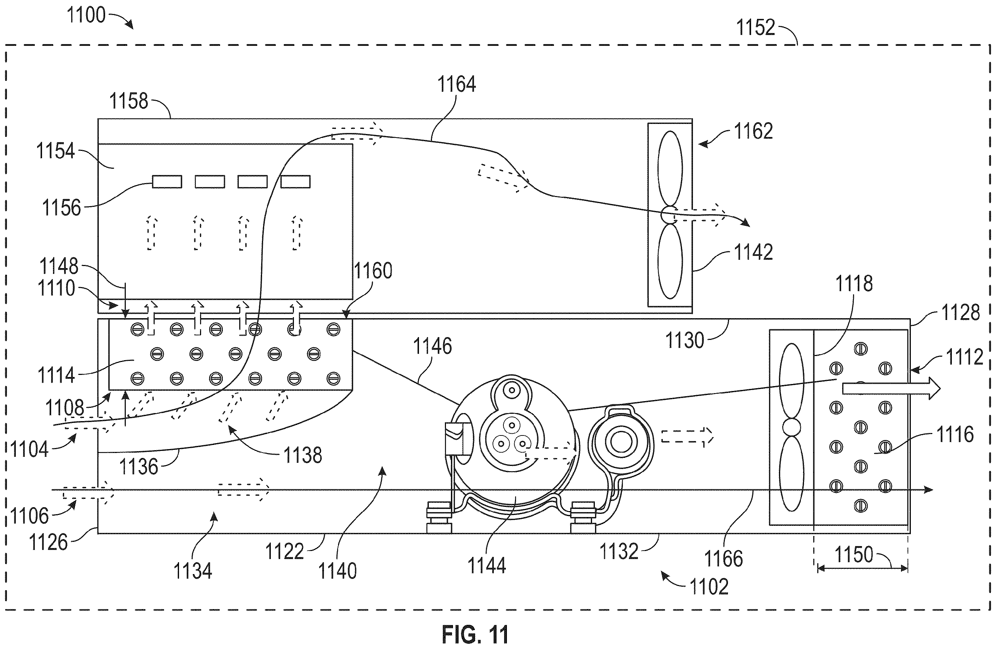

FIG. 11 shows a diagrammatic view of an example of a cooling system 1100 (e.g., a cage cooling system). The cooling system 1100 shares a number of components in common with and operates in a similar fashion to the examples illustrated and described previously (e.g., the cage cooling system 600). For the sake of brevity, these common features will not be again described below in detail. Rather, previous discussion of commonly named or numbered features, unless otherwise indicated, also applies to example configurations of the cooling system 1100.

The cooling system 1100 can include a cooling unit 1102 including inlets 1104, 1106, 1108, outlets 1110, 1112, heat exchangers 1114, 1116, and a fan 1118. The cooling unit 1102 can define a housing 1122 including walls 1126, 1128, 1130, 1132, in which the walls 1126, 1128 can be on opposite ends of the housing 1122 and the walls 1130, 1132 can be on opposite sides of the housing 1122. In some examples, the inlet 1104 can be positioned above the inlet 1106, and each inlet 1104, 1106 can be directed into an end of the housing 1122 (e.g., directed into the wall 1126 of the housing 1122). Similarly, the outlet 1112 can be directed into an end of the housing 1122 (e.g., directed into the wall 1128 of the housing 1122). In this way, the inlets 1104, 1106 can be positioned at one end of the housing 1122, while the outlet 1112 can be positioned at the other end of the housing 1122.

The heat exchangers 1114, 1116 can be positioned within and supported by the housing 1122. For example, the heat exchanger 1114 can be coupled, mounted, etc., to the wall 1130 (e.g., a top wall of the housing 1122), while the heat exchanger 1116 can be coupled, mounted, etc., to either or all of the walls 1128, 1130, 1132 of the housing 1122. The housing 1122 can also define an internal volume 1134 in which air flows though. The cooling unit 1102, and the housing 1122 more specifically, can include a barrier 1136 that separates or otherwise partitions the internal volume 1134 into two portions 1138, 1140 to separate flow paths of air through the cooling unit 1102. In this way, the portions 1138, 1140 of the internal volume 1134 are fluidly isolated from each other, which can, advantageously, provide that there is a sufficient amount of cooling air flow provided to a card cage (and the electrical computing components supported by the card cage), as described below. In some cases, therefore, the portion 1138 of the internal volume 1134 can be smaller than the portion 1140 of the internal volume 1134, to for example, provide that there is not only a smaller flow rate of air passing through or over the heat exchanger 1114, but also that there is a greater flow rate of air passing through or over the heat exchanger 1116.

Still further, the fluidic isolation by the barrier 1136 can ensure that each fan can be dedicated solely to either cooling air flow or heat removal air flow. For example, the fan 1118 can drive heat removal air flow through the cooling unit 1102, while a fan 1142 can drive cooling air flow through the cooling unit 1102 (e.g., can pull air through the inlet 1108, across the heat exchanger 1114, out the outlet 1110, into the intlet1 1160, and out the outlet 1162). This can be especially advantageous because, for example, each fan may be dedicated to its own cooling processes and loops (e.g., computer implemented methods), and it may be difficult, or at least undesirable, to increase the variability where multiple fans are used for the same loops (e.g., evaporation and condensation). Isolating these flow paths, each with their own dedicated fan, can improve the predictability of cooling.

In some examples, the cooling unit 1102 can include a compressor 1144, which can be positioned within the housing 1122 (e.g., coupled to the wall 1132, which can be a bottom wall of the housing 1122) and a refrigeration loop 1146 fluidly coupled to the heat exchanger 1114 and the heat exchanger 1116 (e.g., refrigerant flowing between the heat exchangers 1114, 1116, past the compressor 1144, etc.). In some cases, the heat exchanger 1114 can be an evaporator so as to cool an air flow as the air flow passes through or over the evaporator (e.g., the coils thereof), while the heat exchanger 1116 can be a condenser so as to transfer heat to the heat removal air flow as this air flow passes through or over the condenser (e.g., the coils thereof). In some cases, the heat exchanger 1116 can be positioned downstream of the fan 1118, which can allow the fan 1118 to force air over, through, across, etc., the heat exchanger 1116 (e.g., rather than having air pulled through the heat exchanger 1116, if, for example, the heat exchanger 1116 were positioned upstream of the fan 1118).

In some cases, the heat exchanger 1114 can be positioned within the housing 1122 of the cooling unit 1102, such that, the heat exchanger 1114 is parallel to the housing 1122 (and substantially perpendicular to the heat exchanger 1116). For example, a longitudinal axis of the heat exchanger 1114 can be substantially parallel to a longitudinal axis of the housing 1122, while a longitudinal axis of the heat exchanger 1114 can be substantially perpendicular to a longitudinal axis of the heat exchanger 1116. In some configurations, a flow path through, across, over, etc., the heat exchanger 1114 can be substantially parallel to a height 1148 (or thickness) of the heat exchanger 1114. For example, the flow path extends in the same direction as the height 1148 of the heat exchanger 1114. Similarly, a flow path through, across, over, etc., the heat exchanger 1116 can be substantially parallel to a thickness 1150 (or height) of the heat exchanger 1116. For example, the flow path extends in the same direction as the thickness 1150 of the heat exchanger 1116.

In some examples, a height or thickness of a heat exchanger (e.g., the evaporator) can dictate the cooling capability of the air flow. For example, the greater the height or thickness, the higher the cooling capability (and colder the temperature of the cooling air flow provided to the card cage), at least because there is more surface area (and more time) that the cooling air flow is passed over the heat exchanger. Accordingly, the height or thickness can be adjusted to accommodate different desired cooling capabilities. In some cases, for example, the height 1148 or the thickness of the heat exchanger 1114 can vary based on cooling capabilities. In some cases, a height (or distance in the case of the cooling system 1300) between the outlet 1160 of the cooling unit 1102 (e.g., the provides cool air) and an inlet of the card cage 1154 can be adjusted to accommodate different cooling capabilities. For example, the larger the height the higher the cooling capacity (e.g., because more dead space in the height is provided by cooled air). In some cases, this height (or distance) can be about 44.45 millimeters (e.g., corresponding to 1U), about 88.90 millimeters (e.g., corresponding to 2U), 133.35 millimeters (e.g., corresponding to 3U), etc. In some cases, this height (or distance) can be less than or equal to 133.35 millimeters, 88.90 millimeters, 44.45 millimeters, etc. In some cases, this height (or distance) can be greater than or equal to 44.45 millimeters, 88.90 millimeters, 133.35 millimeters.

In some examples, the cooling unit 1102 can be placed within an enclosure, such as, for example, a rack (e.g., an electronics rack, a server rack, a computing rack, etc.). Th rack can include a card cage supporting one or more electrical devices (e.g., electrical computing devices). For example, the cooling system 1100 can include an enclosure 1152 (e.g., an electronics rack), a card cage 1154 supporting one or more electrical computing devices 1156, and a housing 1158. The housing 1158 can contain and support the card cage 1154 (e.g., and the electrical computing devices 1156) and the fan 1142. Further, the housing 1158 can include an inlet 1160 and an outlet 1162. The inlet 1160 of the housing 1158 can be aligned with and fluidly coupled to the outlet 1110 of the cooling unit 1102. Similarly to the fan 1118, the fan 1142 can be aligned with (and can be positioned within) the outlet 1162.

The cooling unit 1102 can advantageously be a single monolithic component that can quickly and easily upgrade enclosures 1152 that lack cooling capabilities (e.g., sufficient cooling capabilities). For example, some enclosures, such as the enclosure 1152 without the cooling unit 1102, lack cooling capabilities other than a fan. However, a cooling unit 1102 can inserted into the enclosure 1152, at once, to upgrade the enclosure 1152 to improve its air cooling abilities. In this way, various enclosures 1152 can be retrofitted with a cooling unit (e.g., the cooling unit 1102) to provide improved cooling capabilities without needing to replace the entire enclosure 1152. This can, advantageously, decrease downtime for the computing devices (e.g., the electrical computing devices 1156) since the cooling unit 1102 can simply be installed in the enclosure 1152.

Further, avoiding the replacement of the entire enclosure 1152 ensures that electrical power can be continuously provided to the electrical computing devices, so as to ensure that memory (e.g., volatile random access memory ("VRAM")) is not lost (e.g., during upgrades, retrofitting, etc.). In some cases, when the computing devices 1156 are GPUs, or other Artificial Intelligence ("AI") computing devices (e.g., Tensor Processing Units ("TPUs"), neural processing units, etc.), more power can be provided to these components and these components therefore generate more heat. Accordingly, the cooling unit 1102 (or other cooling units) can be especially important for those enclosures (e.g., electronics racks) that run AI models (e.g., for execution, training, etc.).

As described above, the cooling system 1100 can provide cool air to computing devices to transfer heat away from these devices. For example, air flows along a flow path 1164, in which ambient air flows through the inlet 1104 into the portion 1138 of the internal volume 1134, flows upwardly across (or through) the heat exchanger 1114, which cools the air (e.g., removes heat therefrom). Then, the cooled air flows upwardly out of the outlet 1110 of the cooling unit 1102 and into the inlet of the housing 1158, flows upwardly through the card cage 1154 (e.g., in the plenum of the card cage 1154) and transfers heat form the electric components supported by the card cage 1154 to the cooled air. The cooled air flow flows upwardly and is emitted out the outlet 1162 of the housing 1158 (and outside the enclosure 1152 and broader cooling system 1100). In some cases, the fan 1142 can drive the air flow along the flow path 1164 (e.g., pull the air from the ambient environment through the inlet 1104 and eject the air out the outlet 1162). Air also flows along a flow path 1166, in which ambient air flows from the inlet 1106 into the portion 1140 of the internal volume 1134, flows (e.g., longitudinally across the cooling unit 1102) across the heat exchanger 1116 where the air flow absorbs heat therefrom, and is emitted out the outlet 1112. Similarly to the fan 1142, the fan 1118 can drive the air flow along the flow path 1166 (e.g., pull the air from the ambient environment through the inlet 1106 and eject the air out the outlet 1112). In some cases, in a similar way as the barrier 1136, the wall 1130 can isolate the flow paths 1164, 1166 and ensure that, for example, air does not leak between the flow paths 1164, 1166 (e.g., air flowing downwardly from the flow path 1164 into the flow path 1166).

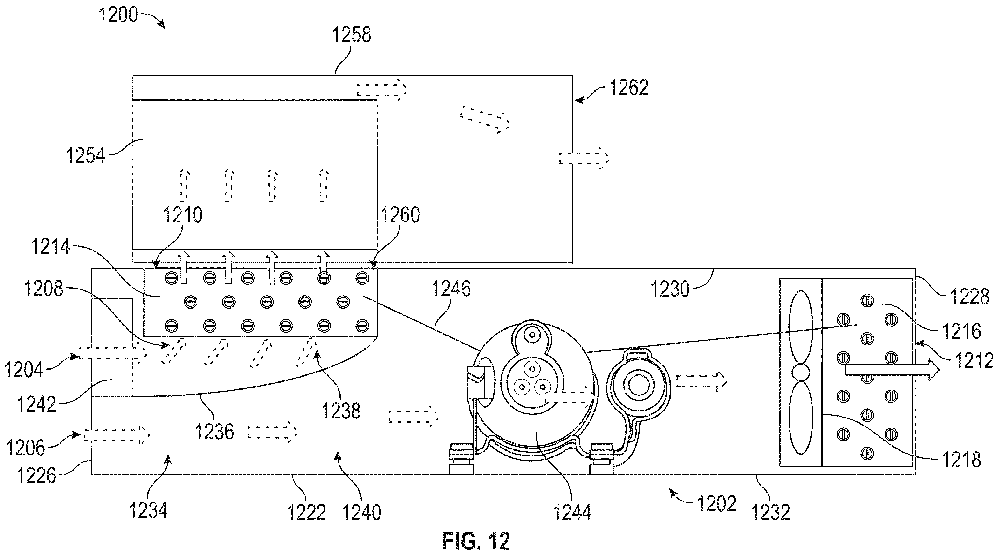

FIG. 12 shows a diagrammatic view of an example of a cooling system 1200 (e.g., a cage cooling system). The cooling system 1200 shares a number of components in common with and operates in a similar fashion to the examples illustrated and described previously (e.g., the cooling systems 600, 1100). For the sake of brevity, these common features will not be again described below in detail. Rather, previous discussion of commonly named or numbered features, unless otherwise indicated, also applies to example configurations of the cooling system 1200.

For example, the cooling system 1200 can include a cooling unit 1202 including a inlets 1204, 1206, 1208, outlets 1210, 1212, heat exchangers 1214, 1216, fans 1218, 1242 a housing 1222 having walls 1226, 1228, 1230, 1232, an internal volume 1234, a barrier 1236 that partitions the internal volume 1234 into portions 1238, 1240, a compressor 1244, and a refrigeration loop 1246. The cooling system 1200 can include a card cage 1254, a housing 1258, an inlet 1260, and an outlet 1262.

In some cases, rather than having the fan 1242 be positioned within the housing 1258 (e.g., that contains and supports the card cage 1254), the cooling unit 1202 can include the fan 1242. For example, the fan 1242 can be positioned within the internal volume 1234 of the housing 1222, specifically, positioned within the portion 1238 of the internal volume 1234. In some cases, the fan 1242 can be coupled to a wall of the housing 1222 of the cooling unit 1202 (e.g. the wall 1226, which can be an end wall of the housing 1222, such as, a front end of the housing 1222). In some configurations, the fan 1242 can be aligned with the inlet 1204, and can be positioned downstream of the inlet 1204. In some cases, the fan 1242 can be positioned within the inlet 1204. In some cases, including when enclosures lack fans, the cooling unit 1202 installed in the enclosure can also provide a cooling fan (e.g., the fan 1242 being a cooling fan). Similarly to the other cooling systems described herein, the fan 1242 can draw ambient air into the portion 1238 of the internal volume 1234 to cool the ambient air (e.g., as the ambient air passes across the heat exchanger 1214) that is directed to the card cage 1254.

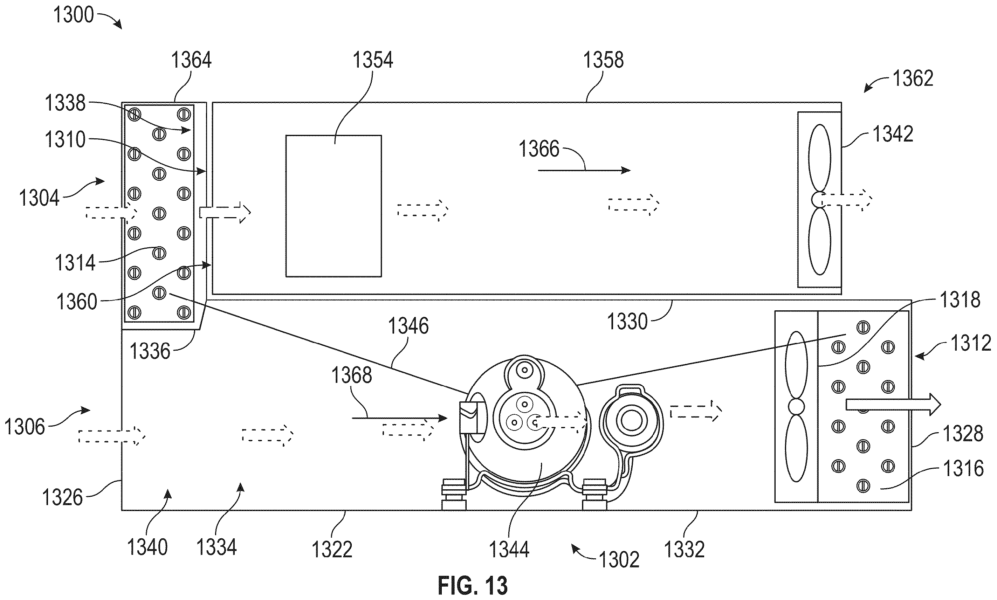

FIG. 13 shows a diagrammatic view of an example of a cooling system 1300 (e.g., a cage cooling system). The cooling system 1300 shares a number of components in common with and operates in a similar fashion to the examples illustrated and described previously (e.g., the cooling systems 600, 1100, 1200). For the sake of brevity, these common features will not be again described below in detail. Rather, previous discussion of commonly named or numbered features, unless otherwise indicated, also applies to example configurations of the cooling system 1300.

For example, the cooling system 1300 can include a cooling unit 1302 including a inlets 1304, 1306, outlets 1310, 1312, heat exchangers 1314, 1316, fans 1318, 1342 a housing 1322 having walls 1326, 1328, 1330, 1332, an internal volume 1334, a barrier 1336 that partitions the internal volume 1334 into portions 1338, 1340, a compressor 1344, and a refrigeration loop 1346. The cooling system 1300 can include a card cage 1354, a housing 1358, an inlet 1360, and an outlet 1362.

In some cases, rather than having two inlets positioned within the portion 1338 of the internal volume 1334, the cooling unit 1302 can position the heat exchanger 1314 within the cooling unit 1302 to eliminate a second inlet, and significantly reduce the amount of volume in the portion 1338 (e.g., as compared to different examples), to, for example, reduce dead space. For example, the longitudinal axis of the heat exchanger 1314 can be substantially perpendicular to the longitudinal axis of the housing 1322 of the cooling unit 1302, and the heat exchanger 1314 can be positioned above the wall 1330 of the housing 1322. For example, the heat exchanger 1314 can be positioned within an upwardly projecting extension of the cooling unit 1302 (e.g., the housing 1322 thereof). For example, an extension 1364 can upwardly extend away from the housing 1322 and each wall 1326, 1328, 1330, 1332 of the housing 1322. For example, the extension 1364 can be coupled to the wall 1330, but in some cases, an internal volume of the extension 1364 (e.g., the portion 1338) is not fluidly coupled to the portion 1340 due to the wall 1330 acting as the barrier 1336. For example, in this case, a portion of the wall 1330 can be the barrier 1336 that separates the internal volume 1334, which can reduce the number of parts needed for the cooling unit 1302 (e.g., during manufacturing).

In some examples, flow paths 1366, 1368 through the cooling system 1300 can be substantially parallel to each other (e.g., with each flow path 1366, 1368 being substantially linear). Air can flow along the flow path 1366, in which, ambient air flows through the inlet 1304, across the heat exchanger 1314, out the outlet 1310, into the inlet 1360, through the card cage 1354, and out the outlet 1362. Similarly, air can flow along the flow path 1368, in which, ambient air flows through the inlet 1306, across the heat exchanger 1316, and out the outlet 1312. In this configuration, rather than supplying cooling air underneath a housing (and card cage), such as, for example, the housing 1258 and the card cage 1254, the extension 1364 and the orientation of the heat exchanger 1314 can provide a flow of cooling air across the housing 1358 and the cage 1354. In other words, the cooling air flows from side to side, rather than from a bottom to a top.

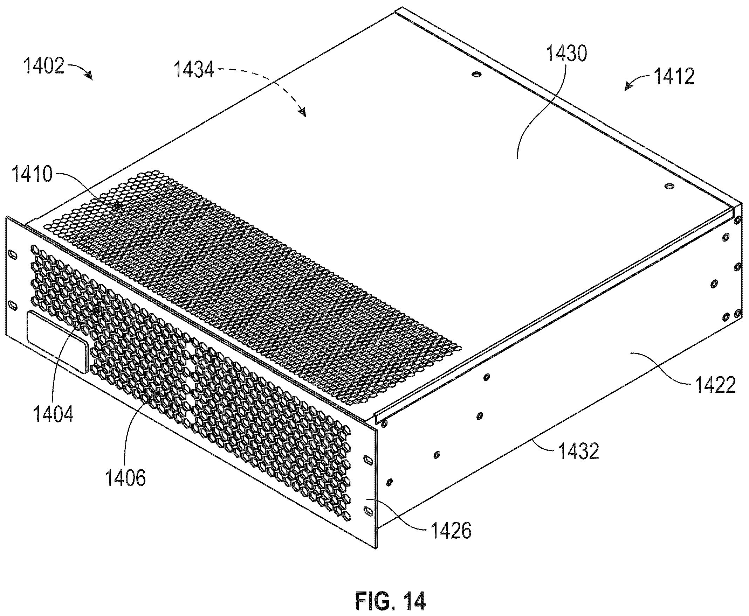

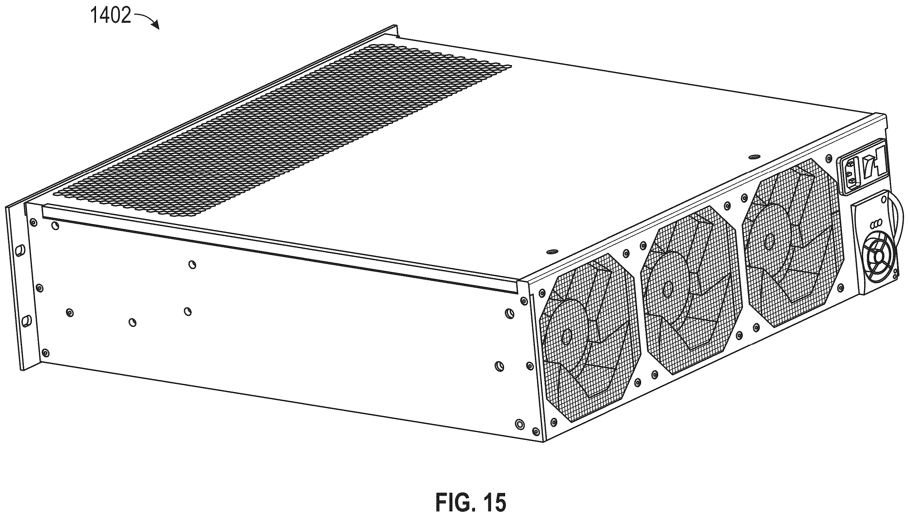

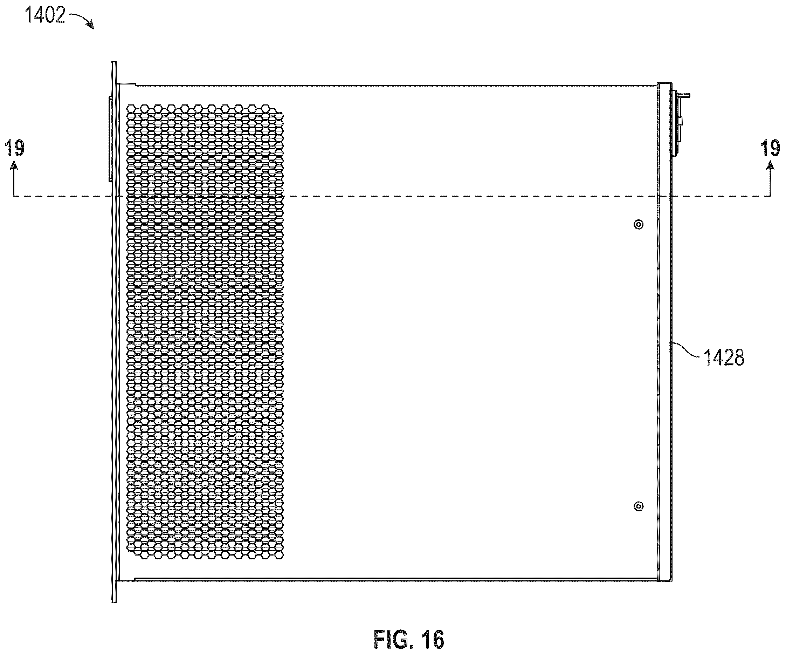

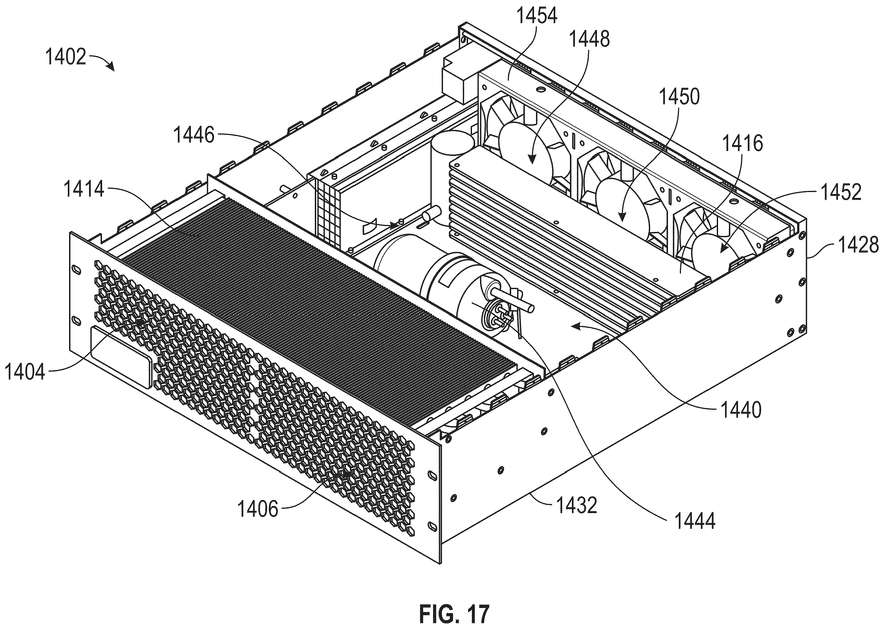

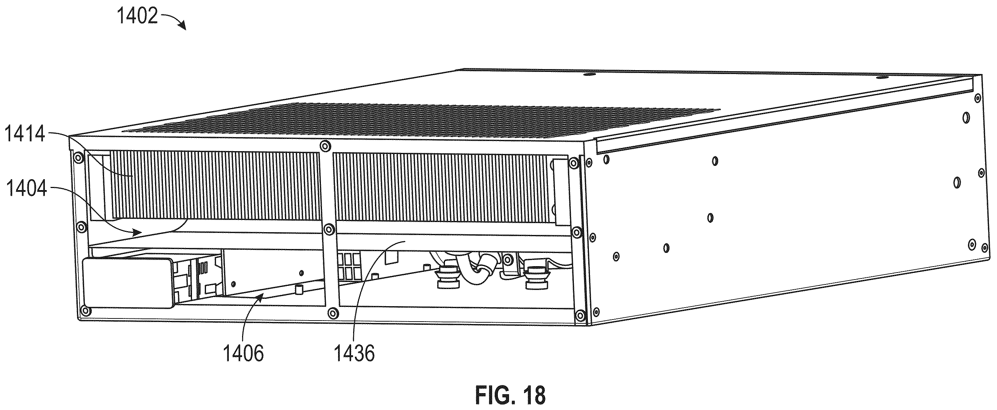

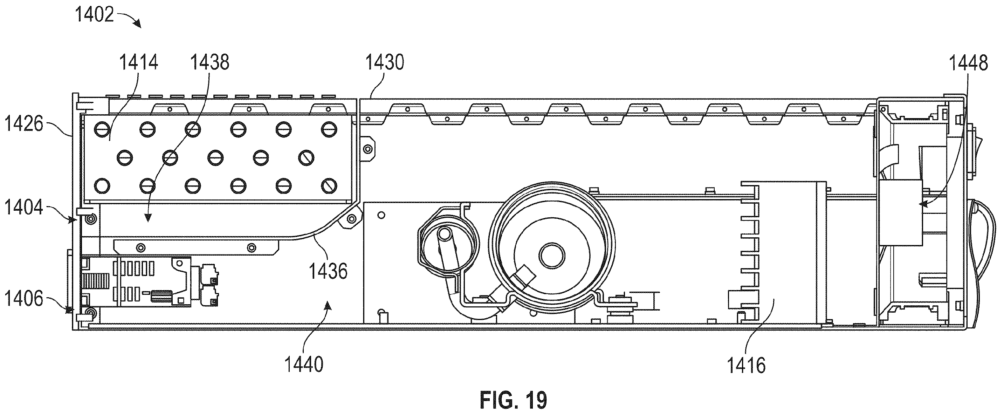

FIG. 14 shows a front isometric view of an example of a cooling unit 1402 (e.g., of a cooling system). FIG. 15 shows a rear isometric view of the cooling unit 1402, FIG. 16 shows a top view of the cooling unit 1402, FIG. 17 shows a front isometric view of the cooling unit 1402 with the top removed for visual clarity, FIG. 18 shows a front isometric view of the cooling unit 1402 with the front removed for visual clarity, and FIG. 19 shows a cross-sectional view of the cooling unit 1402 taken along lines 19-19 of FIG. 16.

The cooling unit 1402 shares a number of components in common with and operates in a similar fashion to the examples illustrated and described previously (e.g., the cooling units 602, 700, 1102, 1202, 1302). For the sake of brevity, these common features will not be again described below in detail. Rather, previous discussion of commonly named or numbered features, unless otherwise indicated, also applies to example configurations of the cooling unit 1402.

For example, the cooling unit 1402 can include a inlets 1404, 1406, outlets 1410, 1412, heat exchangers 1414, 1416, a housing 1422 having walls 1426, 1428, 1430, 1432, an internal volume 1434, a barrier 1436 that partitions the internal volume 1434 into portions 1438, 1440, a compressor 1444, and a refrigeration loop 1446.

In some examples, the cooling unit 1402 can include a plurality of fans fluidly coupled to the portion 1440 of the internal volume 1434 of the housing 1422. For example, the cooling unit 1402 can include fans 1448, 1450, 1452, positioned within the internal volume 1434 (e.g., the portion 1440 of the internal volume 1434). Each fan 1448, 1450, 1452 can be coupled to one or more walls of the housing 1422, such as, for example, the wall 1432 (e.g., the bottom wall), the wall 1428 (e.g., the back wall), the wall 1430 (e.g., the top wall), one or more side walls, etc. In some cases, the fans 1448, 1450, 1452 can be positioned downstream of the heat exchanger 1416, so as to pull air across the heat exchanger 1416, rather than forcing air across the heat exchanger 1416 (e.g., pushing the air onto the heat exchanger 14156). This downstream positioning of the fans 1448, 1450, 1452 relative to the heat exchanger 1416 can more gently direct air across the heat exchanger 1416, and may, for example, improve heat transfer between the heat exchanger and the air directed across the heat exchanger 1416. Although three fans 1448, 1450, 1452 are shown in FIG.16, the cooling unit 1402 can have other numbers of fans (e.g., one, two, four, etc.). In some cases, each fan 1448, 1450, 1452 can be aligned with the inlet 1406. In this way, a relatively straight flow path (e.g., unimpeded, non-tortuous, etc.) can be provide, which may improve heat transfer. In some cases, the fans 1448, 1450, 1452 can be positioned in parallel (e.g., rather than series), and can each be aligned with each other. Further, the fans 1448, 1450, 1452 can be coupled together. For example, a frame 1454 can couple the fans 1448, 1450, 1452 together, with the frame surrounding each fan 1448, 1450, 1452. In some cases, the frame 1454 can have a shape (e.g., a peripheral shape) that corresponds to the shape of the outlet 1412, such as, for example, a rectangle, a square, a circle, etc.

In some examples, the barrier 1436 can be coupled between the walls 1426, 1430. For example, one end of the barrier 1436 can be coupled to the wall 1426 (e.g., the front wall) and an opposite end of the barrier 1436 can be coupled to the to the wall 1430 (e.g., the top wall). In some cases, the barrier 1436, before being installed in the cooling unit 1400, can be flat, planar, etc., (e.g., formed out of a flat sheet of a material such as metal). In some cases, the barrier 1436 can be curved (e.g., at least a section of the barrier 1436 between the ends of the barrier 1436 can be curved). For example, the barrier 1436 can curve upwardly towards the wall 1430. More specifically, the barrier 1436 can extend substantially along a longitudinal axis of the cooling unit 1400 (e.g., the housing 1422 thereof), can curve upwardly therefrom, and extend in a direction perpendicular to the longitudinal axis of the cooling unit 1400 and along the heat exchanger 1414 (e.g., until the barrier 1436 is coupled to the wall 1430).

In some examples, each inlet 1404, 1406, and the outlets 1410, 1412 can include one or more perorations (or apertures, holes, etc.) fluidly coupled thereto. For example, a first set of perforations can be positioned upstream of the inlets 1404, 1406, and a second set of perforations can be positioned downstream of the outlet 1410, and a third set of perforations can be positioned downstream of the outlet 1412. In some cases, the first set of perforations can be directed into the wall 1426, the second set of perforations can be directed into the wall 1430, and the third set of perforations can be directed into the wall 1428. Each perforation can have different shapes, for example, each perforation can be circular, hexagonal, octagonal, etc.

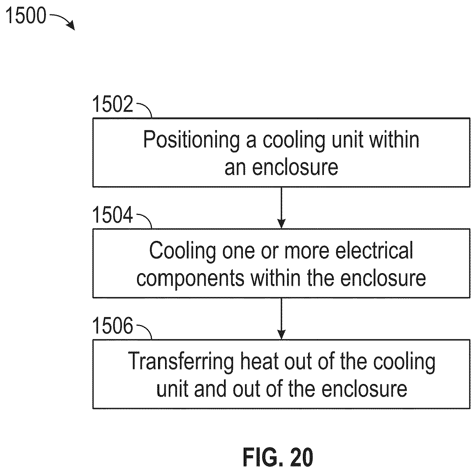

FIG. 20 shows a flowchart of a process 1500 of installing a cooling unit within an enclosure (e.g., an electronics rack) and cooling components of the enclosure. The process 1500 can be implemented using any of the cooling systems, cooling units, etc., described herein. Further, some or all of the blocks of the process 1500 can be implemented with a computing device, as appropriate.

At 1502, the process 1500 can include positioning a cooling unit within an enclosure. In some cases, this can include positioning the cooling unit below a card cage within the enclosure. In some configurations, this can include, when installed or otherwise positioned appropriately, coupling, mounting, etc., the cooling unit to the enclosure (e.g., a frame thereof).

At 1504, the process 1500 can include cooling one or more electrical components within the enclosure (e.g., within a card cage of the enclosure). In some cases, this can include directing first air through an inlet, across a first heat exchanger (e.g., an evaporator) thereby cooling the first air (e.g., by transferring heat from the first air and to the first heat exchanger), and out a first outlet into a card cage within the enclosure.

At 1506, the process 1500 can include transferring heat out of the cooling unit and out of the enclosure. In some cases, this can include directing second air through a second inlet, across a second heat exchanger (e.g., a condenser) thereby heating the second air (e.g., by transferring heat from the second heat exchanger to the second air), and out a second outlet and out of the enclosure.

### FURTHER EXAMPLES

Example 1. A cooling unit for an enclosure that is an electronics rack, the cooling unit comprising: a housing defining an internal volume; a barrier separating the internal volume into a first portion of the internal volume and a second portion of the internal volume; a first inlet directing first air into the first portion of the internal volume; a second inlet directing second air into the second portion of the internal volume; a first outlet fluidly coupled to the first portion of the internal volume; a second outlet fluidly coupled to the second portion of the internal volume; a first heat exchanger positioned within the internal volume and fluidly coupled to the first inlet; and a second heat exchanger positioned within the internal volume and fluidly coupled to the second inlet; wherein the first air flows along a first flow path through the first inlet, across the first heat exchanger thereby cooling the air, and out the first outlet to direct the cooled first air to a card cage having one or more electrical computing components therein; and wherein the second air flows along a second flow path through the second inlet, across the second heat exchanger thereby transferring heat from the second heat exchanger to the second air, and out the second outlet to direct the heated second air out of the enclosure.

Example 2. The cooling unit of Example 1, wherein the cooling unit is dimensioned to be placed in the enclosure, wherein the enclosure is an electronics rack that includes a card cage supporting one or more electrical computing components.

Example 3. The cooling unit of Example 1 or Example 2, wherein the first heat exchanger is positioned between the first inlet and the first outlet.

Example 4. The cooling unit of any of Examples 1-3, wherein a longitudinal axis of the first heat exchanger is substantially parallel to a longitudinal axis of the housing of the cooling unit; and wherein the second air flows substantially perpendicular relative to the longitudinal axis of the cooling unit.

Example 5. The cooling unit of any of Examples 1-4, further comprising a refrigeration loop that fluidly couples a refrigerant to the first heat exchanger and the second heat exchanger, the refrigerant being a two-phase liquid refrigerant.

Example 6. The cooling unit of any of Examples 1-3 or Example 5, wherein a longitudinal axis of the first heat exchanger is substantially perpendicular to a longitudinal axis of the housing of the cooling unit.

Example 7. The cooling unit of any of Examples 1-6, further comprising: a first fan fluidly coupled to the first inlet, the first fan being positioned downstream of the first inlet; and a second fan fluidly coupled to the second inlet, the second fan being positioned upstream of the second heat exchanger.

Example 8. The cooling unit of any of Examples 1-7, further comprising an extension coupled to the housing; wherein the extension defines the first inlet and the first portion of the internal volume; wherein the first heat exchanger is positioned within the extension; and wherein the first flow path is substantially parallel to the second flow path.

Example 9. The cooling unit of Example 8, wherein the extension is aligned with a card cage supported by the enclosure when installed; and wherein the cooled first air flows substantially parallel to a longitudinal axis of the housing.

Example 10. The cooling unit of Example 8 or Example 9, wherein a top wall of the housing of the cooling unit defines the barrier.

Example 11. The cooling unit of any of Examples 1-10, wherein a longitudinal axis of the first heat exchanger is substantially perpendicular to a longitudinal axis of the second heat exchanger; or wherein the longitudinal axis of the first heat exchanger is substantially parallel to the longitudinal axis of the second heat exchanger.

Example 12. A method of installing a cooling unit within an enclosure that is an electronics rack, the method comprising: positioning the cooling unit in the enclosure below a card cage to be cooled, the cooling unit including a first inlet, a second inlet, a first outlet, a second outlet, a first heat exchanger, and a second heat exchanger; directing first air through a first inlet, across the first heat exchanger thereby cooling the first air, and out the first outlet into the card cage; and directing second air through a second inlet, across the second heat exchanger thereby transferring heat from the second heat exchanger to the second air, and out the second outlet and out of the enclosure.

Example 13. The method of Example 12, wherein the cooling unit includes a barrier that separates an internal volume of a housing of the cooling unit into a first portion and a second portion; and wherein the first inlet and the first outlet are fluidly coupled to the first portion of the internal volume; wherein the second inlet and the second outlet are fluidly coupled to the second portion of the internal volume.

Example 14. The method of Example 13, wherein the enclosure includes a first fan and the cooling unit includes a second fan, and further comprising: activating the first fan to direct the first air through the cooling unit; and activating the second fan to direct the second air through the cooling unit.

Example 15. The method of Example 13 or Example 14, wherein the cooling unit includes a first fan and a second fan, and further comprising: activating the first fan to direct the first air through the cooling unit; and activating the second fan to direct the second air through the cooling unit.

Similarly, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "only one of," or "exactly one of." For example, a list of "only one of A, B, or C" indicates options of: A, but not B and C; B, but not A and C; and C, but not A and B. In contrast, a list preceded by "one or more" (and variations thereon) and including "or" to separate listed elements indicates options of one or more of any or all the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more A, one or more B, and one or more C. Similarly, a list preceded by "a plurality of" (and variations thereon) and including "or" to separate listed elements indicates options of one or more of each of multiple of the listed elements. For example, the phrases "a plurality of A, B, or C" and "two or more of A, B, or C" indicate options of: one or more A and one or more B; one or more B and one or more C; one or more A and one or more C; and one or more A, one or more B, and one or more C.

Also as used herein, unless otherwise limited or defined, "substantially parallel" indicates a direction that is within ± 12 degrees of a reference direction (e.g., within ± 6 degrees), inclusive.

Also as used herein, unless otherwise limited or defined, "substantially perpendicular" indicates a direction that is within ± 12 degrees of perpendicular a reference direction (e.g., within ± 6 degrees), inclusive.

Also as used herein, unless otherwise limited or defined, "integral" and derivatives thereof (e.g., "integrally") describe elements that are manufactured as a single piece without fasteners, adhesive, or the like to secure separate components together. For example, an element stamped, cast, or otherwise molded as a single-piece component from a single piece of sheet metal or using a single mold, without rivets, screws, or adhesive to hold separately formed pieces together is an integral (and integrally formed) element. In contrast, an element formed from multiple pieces that are separately formed initially then later connected together, is not an integral (or integrally formed) element.

Additionally, unless otherwise specified or limited, the terms "about" and "approximately," as used herein with respect to a reference value, refer to variations from the reference value of ± 15% or less, inclusive of the endpoints of the range. Similarly, the term "substantially equal" (and the like) as used herein with respect to a reference value refers to variations from the reference value of less than ± 10%, inclusive. Where specified, "substantially" can indicate in particular a variation in one numerical direction relative to a reference value. For example, "substantially less" than a reference value (and the like) indicates a value that is reduced from the reference value by 10% or more, and "substantially more" than a reference value (and the like) indicates a value that is increased from the reference value by 10% or more.

Also as used herein, unless otherwise limited or specified, "substantially identical" refers to two or more components or systems that are manufactured or used according to the same process and specification, with variation between the components or systems that are within the limitations of acceptable tolerances for the relevant process and specification. For example, two components can be considered to be substantially identical if the components are manufactured according to the same standardized manufacturing steps, with the same materials, and within the same acceptable dimensional tolerances (e.g., as specified for a particular process or product).

The following discussion is presented to enable a person skilled in the art to make and use examples of the present disclosure. Various modifications to the illustrated examples will be readily apparent to those skilled in the art, and the generic principles herein can be applied to other examples and applications without departing from examples of the disclosure. Thus, examples of the disclosure are not intended to be limited to examples shown but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of examples of the disclosure. Skilled artisans will recognize the examples provided herein have many useful alternatives and fall within the scope of examples of the disclosure. In some implementations, devices or systems disclosed herein can be utilized, manufactured, or installed using methods embodying aspects of the invention. Correspondingly, any description herein of particular features, capabilities, or intended purposes of a device or system is generally intended to include disclosure of a method of using such devices for the intended purposes, a method of otherwise implementing such capabilities, a method of manufacturing relevant components of such a device or system (or the device or system as a whole), and a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as examples of the invention, of the utilized features and implemented capabilities of such device or system.

Features which are described in the context of separate embodiments may be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. Feature(s) of the cooling unit and/or any component or system described may be incorporated into/used in a corresponding method and vice versa.

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order.

It will be appreciated by those skilled in the art that while the invention has been described above in connection with particular examples and examples, the invention is not necessarily so limited, and that numerous other examples, examples, uses, modifications and departures from the examples, examples and uses are intended to be encompassed by the claims attached hereto. The entire disclosure of each patent and publication cited herein is incorporated by reference, as if each such patent or publication were individually incorporated by reference herein. Various features and advantages of the invention are set forth in the following claims.

## Claims

1. A cooling unit for an enclosure that is an electronics rack, the cooling unit comprising:
a housing defining an internal volume;
a barrier separating the internal volume into a first portion of the internal volume and a second portion of the internal volume;
a first inlet directing first air into the first portion of the internal volume;
a second inlet directing second air into the second portion of the internal volume;
a first outlet fluidly coupled to the first portion of the internal volume;
a second outlet fluidly coupled to the second portion of the internal volume;
a first heat exchanger positioned within the internal volume and fluidly coupled to the first inlet; and
a second heat exchanger positioned within the internal volume and fluidly coupled to the second inlet;
wherein the first air flows along a first flow path through the first inlet, across the first heat exchanger thereby cooling the air, and out the first outlet to direct the cooled first air to a card cage having one or more electrical computing components therein; and
wherein the second air flows along a second flow path through the second inlet, across the second heat exchanger thereby transferring heat from the second heat exchanger to the second air, and out the second outlet to direct the heated second air out of the enclosure.

2. The cooling unit of claim 1, wherein the cooling unit is dimensioned to be placed in the enclosure, wherein the enclosure is an electronics rack that includes a card cage supporting one or more electrical computing components.

3. The cooling unit of claim 1 or claim 2, wherein the first heat exchanger is positioned between the first inlet and the first outlet.

4. The cooling unit of claim 1, claim 2 or claim 3, wherein a longitudinal axis of the first heat exchanger is substantially parallel to a longitudinal axis of the housing of the cooling unit; and
wherein the second air flows substantially perpendicular relative to the longitudinal axis of the cooling unit.

5. The cooling unit of claim 1 or of any of claims 2 to 4, further comprising a refrigeration loop that fluidly couples a refrigerant to the first heat exchanger and the second heat exchanger, the refrigerant being a two-phase liquid refrigerant.

6. The cooling unit of claim 1 or of any of claims 2 to 5, wherein a longitudinal axis of the first heat exchanger is substantially perpendicular to a longitudinal axis of the housing of the cooling unit.

7. The cooling unit of claim 1 or of any of claims 2 to 6, further comprising:
a first fan fluidly coupled to the first inlet, the first fan being positioned downstream of the first inlet; and
a second fan fluidly coupled to the second inlet, the second fan being positioned upstream of the second heat exchanger.

8. The cooling unit of claim 1 or of any of claims 2 to 7, further comprising an extension coupled to the housing;
wherein the extension defines the first inlet and the first portion of the internal volume;
wherein the first heat exchanger is positioned within the extension; and
wherein the first flow path is substantially parallel to the second flow path.

9. The cooling unit of claim 8, wherein the extension is aligned with a card cage supported by the enclosure when installed; and
wherein the cooled first air flows substantially parallel to a longitudinal axis of the housing.

10. The cooling unit of claim 8 or claim 9, wherein a top wall of the housing of the cooling unit defines the barrier.

11. The cooling unit of claim 1 or of any of claims 2 to 10, wherein a longitudinal axis of the first heat exchanger is substantially perpendicular to a longitudinal axis of the second heat exchanger; or
wherein the longitudinal axis of the first heat exchanger is substantially parallel to the longitudinal axis of the second heat exchanger.

12. A method of installing a cooling unit within an enclosure that is an electronics rack, the method comprising:
positioning the cooling unit in the enclosure below a card cage to be cooled, the cooling unit including a first inlet, a second inlet, a first outlet, a second outlet, a first heat exchanger, and a second heat exchanger;
directing first air through a first inlet, across the first heat exchanger thereby cooling the first air, and out the first outlet into the card cage; and
directing second air through a second inlet, across the second heat exchanger thereby transferring heat from the second heat exchanger to the second air, and out the second outlet and out of the enclosure.

13. The method of claim 12, wherein the cooling unit includes a barrier that separates an internal volume of a housing of the cooling unit into a first portion and a second portion; and
wherein the first inlet and the first outlet are fluidly coupled to the first portion of the internal volume;
wherein the second inlet and the second outlet are fluidly coupled to the second portion of the internal volume.

14. The method of claim 13, wherein the enclosure includes a first fan and the cooling unit includes a second fan, and further comprising:
activating the first fan to direct the first air through the cooling unit; and
activating the second fan to direct the second air through the cooling unit.

15. The method of claim 13 or claim 14, wherein the cooling unit includes a first fan and a second fan, and further comprising:
activating the first fan to direct the first air through the cooling unit; and
activating the second fan to direct the second air through the cooling unit.
